**Europäisches Patentamt**

**European Patent Office**

**Office européen des brevets**

(19)

(11) Veröffentlichungsnummer: **0 129 498**
**B1**

(12) # EUROPÄISCHE PATENTSCHRIFT

(45) Veröffentlichungstag der Patentschrift:
**07.01.87**

(21) Anmeldenummer: **84730054.8**

(22) Anmeldetag: **21.05.84**

(51) Int. Cl.⁴: **G 09 F 9/00**, H 03 K 17/78 //
G05B19/04

(54) **Elektrisches Gerät mit einer Schaltungsanordnung zur Anzeige mehrerer Betriebszustände durch Lichtdioden.**

(30) Priorität: **27.05.83 DE 3319779**

(43) Veröffentlichungstag der Anmeldung:
**27.12.84 Patentblatt 84/52**

(45) Bekanntmachung des Hinweises auf die Patenterteilung:
**07.01.87 Patentblatt 87/2**

(84) Benannte Vertragsstaaten:
**AT BE CH DE IT LI NL SE**

(56) Entgegenhaltungen:
**DE - A - 2 928 905
FR - A - 2 437 091
US - A - 3 708 672
US - A - 4 328 539**

**ELECTRICAL DESIGN NEWS, Band 27, Nr. 3, Februar
1982, Seite 176, Boston, Mass., US; M.R. LEVINE:
"Optoisolator simplifies current pulser"**

(73) Patentinhaber: **Siemens Aktiengesellschaft Berlin und
München, Wittelsbacherplatz 2, D-8000 München 2 (DE)**

(72) Erfinder: **Rieger, Peter, Dipl.-Ing., Brauerstrasse 8,
D-1000 Berlin 45 (DE)**

## Beschreibung

Die Erfindung betrifft ein elektrisches Gerät mit einer Schaltungsanordnung zur Anzeige mehrerer Betriebszustände durch Leuchtdioden, die in Reihe geschaltet und an eine Stromversorgungseinrichtung angeschlossen sind, wobei jeder Leuchtdiode eine steuerbare Schalteinrichtung zugeordnet ist, deren Schaltstrecke parallel zur Leuchtdiode und deren Steuereingang an jeweils einen Ausgang des elektrischen Gerätes angeschlossen ist.

Ein derartiges Gerät ist in RPB-electronic-taschenbücher; Nr. 164, 1982 (H. Schreiber: «50 Hobbyschaltungen mit Leuchtdioden») auf Seite 45 beschrieben. Bei der bekannten Anordnung wird eine Kette von in Serie geschalteten Leuchtdioden von einer Betriebsspannungsquelle mit einem durch einen Transistor konstant gehaltenen Strom gespeist. Jeder Leuchtdiode ist als steuerbare Schalteinrichtung jeweils ein Transistor mit seiner Kollektor-Emitter-Strecke als Schaltstrecke parallel geschaltet, wobei die Basis als Steuereingang über einen Basiswiderstand mit jeweils einem Ausgang eines Digitalspeichers verbunden ist. In dem Digitalspeicher, der ebenfalls an die Betriebsspannungsquelle angeschlossen ist, sind die Betriebszustände gespeichert. Gemäss dem anzuzeigenden Betriebszustand steuert der entsprechende Ausgang des Digitalspeichers den zugeordneten Transistor an, so dass dieser entweder sperrt oder leitet. Bei sperrendem Transistor leuchtet die parallel geschaltete Leuchtdiode wegen des durch sie fliessenden Konstantstromes, während bei durchgeschaltetem Transistor dieser die Leuchtdiode kurzschliesst, so dass sie nicht leuchtet.

Wird eine Leuchtdiode infolge eines Defektes hochohmig und befindet sich der parallel geschaltete Transistor in sperrendem Zustand, so hat dies eine Unterbrechung der Stromversorgung für die übrigen Leuchtdioden und damit deren Ausfall als Anzeigeelemente zur Folge.

Die Anzahl der bei dem bekannten Gerät einsetzbaren Leuchtdioden ist begrenzt, weil die Summe der Durchlassspannungen der Leuchtdioden die Höhe der Betriebsspannung nicht übersteigen kann und wegen der Spannungsversorgung des Digitalspeichers durch die Betriebsspannung deren maximale Höhe durch die maximal zulässige Versorgungsspannung des Digitalspeichers festgelegt ist.

Der Erfindung liegt daher die Aufgabe zugrunde, ein elektrisches Gerät mit einer Schaltungsanordnung zur Anzeige mehrerer Betriebszustände durch Leuchtdioden anzugeben, das sich durch eine besonders hohe Funktionssicherheit auszeichnet und bei dem die Zahl der anzeigbaren Betriebszustände beliebig hoch wählbar ist.

Zur Lösung dieser Aufgabe ist bei dem Gerät der eingangs beschriebenen Art erfindungsgemäss die Schalteinrichtung eine Schalteinrichtung mit galvanischer Trennung von Schaltstrecke und Steuereingang; parallel zu jeder Leuchtdiode ist eine Vorrichtung zur Spannungsbegrenzung geschaltet.

Die galvanische Trennung der Schaltstrecke von dem Steuereingang innerhalb jeder Schalteinrichtung bietet den Vorteil, dass die Spannung der Stromversorgungseinrichtung für die in Reihe geschalteten Leuchtdioden und damit die Anzahl der die Betriebszustände anzeigenden Leuchtdioden beliebig hoch gewählt werden kann, ohne dass spannungsmässig eine Anpassung an die Ausgänge des elektrischen Gerätes vorgenommen werden muss.

Ein weiterer Vorteil des erfindungsgemässen Gerätes besteht in den Vorrichtungen zur Spannungsbegrenzung, die jeder Leuchtdiode parallel geschaltet sind. Ist nämlich eine Leuchtdiode infolge eines Defektes hochohmig und die parallele Schaltstrecke der zugeordneten Schalteinrichtung geöffnet, so übernimmt die Vorrichtung zur Spannungsbegrenzung anstelle der defekten Leuchtdiode den Strom und begrenzt die Spannung an der offenen Schaltstrecke. Weiterhin schützen die Vorrichtungen zur Spannungsbegrenzung die Leuchtdioden vor zu hohen Spannungen, so dass auf eine Speisung der in Reihe geschalteten Leuchtdioden durch einen Konstantstrom verzichtet werden kann. Statt dessen genügt für die Stromversorgungseinrichtung der Leuchtdioden eine Spannungsquelle mit strombegrenzendem Vorwiderstand. Sind nämlich alle Schaltstrecken der Schalteinrichtungen bis auf eine geschlossen, so wird der Strom durch die Leuchtdiode, die parallel zu der offenen Schaltstrecke liegt, nur noch durch den Vorwiderstand der Stromversorgung begrenzt, was eine Überlastung der Leuchtdiode zur Folge hätte. In diesem Fall übernimmt die entsprechende Vorrichtung zur Spannungsbegrenzung einen Teil des Stromes und begrenzt die Spannung an der Leuchtdiode.

Als steuerbare Schalteinrichtungen können beispielsweise Relais eingesetzt werden.

Bei einer u.a. der Kosten wegen vorteilhaften Ausführungsform des erfindungsgemässen elektrischen Gerätes besteht jede Schalteinrichtung aus einem Optokoppler; dieser ist ausgangsseitig mit seiner Schaltstrecke parallel zu der jeweiligen Leuchtdiode geschaltet und an seinem Steuereingang mit dem jeweiligen Ausgang des elektrischen Gerätes verbunden.

Als Vorrichtungen zur Spannungsbegrenzung finden vorteilhafterweise Zenerdioden Verwendung, die jeweils antiparallel zur jeweiligen Leuchtdiode geschaltet sind. Dabei sind die Zenerspannungen der Zenerdioden grösser als die Durchbruchsspannungen der jeweils parallel geschalteten Leuchtdioden.

Besonders vorteilhaft ist es, wenn das elektrische Gerät eine Speichervorrichtung enthält, in der die anzuzeigenden Betriebszustände gespeichert sind und an deren Ausgänge die steuerbaren Schalteinrichtungen mit ihren Steuereingängen angeschlossen sind. Wenn die Speichervorrichtung von einem Mikroprocessor gesteuert wird, braucht der Mikroprozessor nur bei Änderung der Betriebszustände auf die Speichervorrichtung zuzugreifen.

Bei einer weiteren vorteilhaften Ausführungsform des erfindungsgemässen elektrischen Geräts in Einschubtechnik weisen die Einschübe eine oder mehrere der Leuchtdioden und jeweils einen Widerstand in einer derartigen elektrischen Verbindung mit der Steckeinrichtung des jeweiligen Einschubs auf, dass im gesteckten Zustand der Einschübe die Leuchtdioden aller Einschübe in Reihe geschaltet und die Widerstände parallel zu einem Vorwiderstand geschaltet sind, der zusammen mit einer Spannungsquelle die Stromversorgungseinrichtung bildet. Der Strom durch sämtliche dann in Reihe geschaltete Leuchtdioden und die Helligkeit ihres Leuchtens ist unabhängig von der Zahl der gesteckten Einschübe, weil die Parallelschaltung der Widerstände zu dem Vorwiderstand der strombegrenzenden Wirkung der Reihenschaltung der Leuchtdioden entgegenwirkt.

Zur Erläuterung der Erfindung ist in

Fig. 1 ein Ausführungsbeispiel des erfindungsgemässen elektrischen Gerätes und in

Fig. 2 ein weiteres Ausführungsbeispiel des erfindungsgemässen elektrischen Gerätes in Einschubtechnik dargestellt.

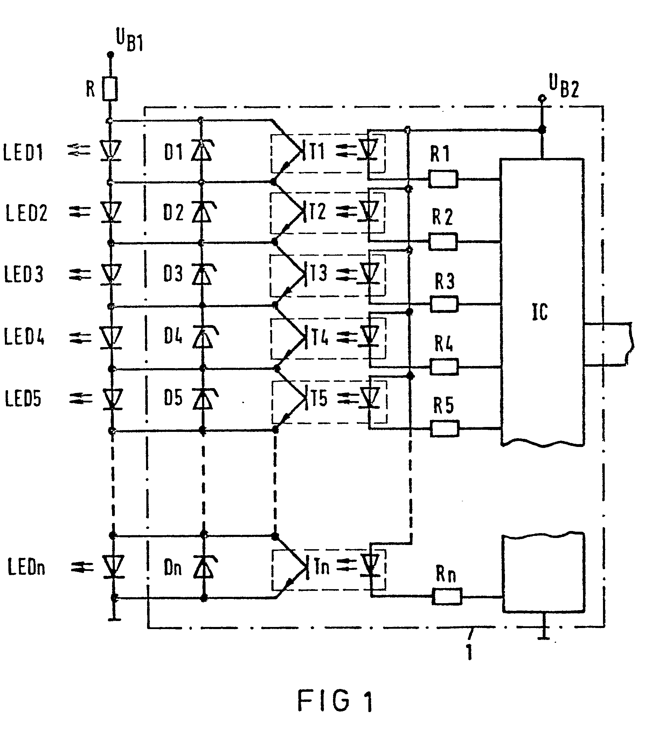

Beim Ausführungsbeispiel nach Fig. 1 ist eine Kette von Leuchtdioden LED1 bis LEDn an eine Stromversorgungseinrichtung mit dem Widerstand R und der Betriebsspannung $U_{B1}$ angeschlossen. Jeder Leuchtdiode LED1 bis LEDn ist jeweils eine Zenerdiode D1 bis Dn als Vorrichtung zur Spannungsbegrenzung und ein Optokoppler T1 bis Tn mit seiner ausgangsseitigen Kollektor-Emitter-Strecke als Schaltstrecke parallel geschaltet. Jeder Optokoppler T1 bis Tn ist mit der Kathode seines Steuereingangs über einen Widerstand R1 bis Rn mit jeweils einem Ausgang einer Speichervorrichtung bestehend aus dem Digitalspeicher IC verbunden, während die Anode eines jeden Optokopplers T1 bis Tn an die Versorgungsspannung $U_{B2}$ des Digitalspeichers IC angeschlossen ist. Gemäss dem anzuzeigenden Betriebszustand steuert der entsprechende Ausgang des Digitalspeichers IC den ihm zugeordneten der Optokoppler T1 bis Tn an, so dass dessen ausgangsseitige Kollektor-Emitter-Strecke entweder sperrt oder leitet. Bei sperrender Kollektor-Emitter-Strecke leuchtet die parallel geschaltete Leuchtdiode wegen des durch sie fliessenden Stromes auf, während bei durchgeschaltetem Optokoppler dieser die parallel liegende Leuchtdiode kurzschliesst, so dass sie nicht leuchtet. Ist eine der Leuchtdioden LED1 bis LEDn infolge eines Defektes hochohmig und befindet sich der parallel liegende Optokoppler in einem sperrenden Zustand, so begrenzt die jeweils parallel geschaltete Zenerdiode die Spannung an der Kollektor-Emitter-Strecke des Optokopplers und übernimmt anstelle der Leuchtdiode den Strom. Das hat zur Folge, dass die Stromversorgung der übrigen Leuchtdioden und damit deren Anzeigefunktion aufrechterhalten bleibt.

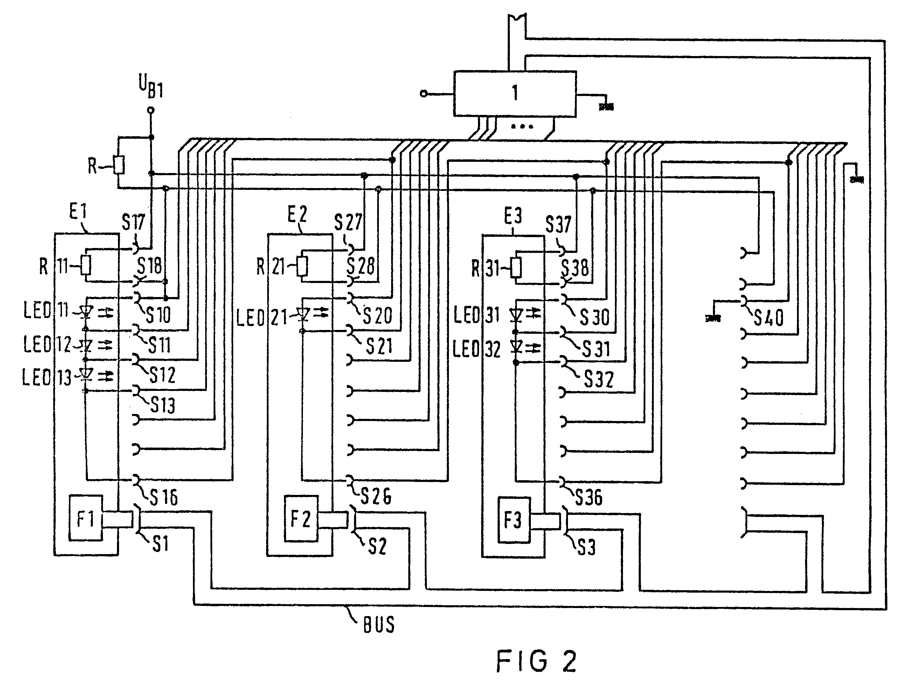

Bei dem Ausführungsbeispiel nach Fig. 2 ist das elektrische Gerät in Einschubtechnik ausgeführt. In der Figur sind vier Steckplätze für Einschübe dargestellt, bei denen jeweils bis zu sechs Betriebszustände durch Leuchtdioden anzeigbar sind. Der Einschub E1 enthält eine Funktionseinheit F1 des elektrischen Gerätes, die über eine Steckvorrichtung S1 mit dem Systembus BUS des elektrischen Gerätes verbunden ist. Zur Anzeige der Betriebszustände der Funktionseinheit F1 sind Leuchtdioden LED11, LED12 und LED13 in Reihe geschaltet und liegen über Steckverbindungen S10, S11, S12 und S13 parallel zu den Kollektor-Emitter-Strecken von nicht dargestellten Optokopplern, die Bestandteile eines in Fig. 1 dargestellten Teils 1 des elektrischen Gerätes sind. Der Einschub E1 enthält weiterhin einen Widerstand R11, der über Steckverbindungen S17 und S18 parallel zu dem Vorwiderstand R einer Stromversorgungseinrichtung mit der Betriebsspannung $U_{B1}$ geschaltet ist. Zwei weitere Einschübe E2 und E3 sind entsprechend dem Einschub E1 aufgebaut: Die Funktioneinheiten F2 bzw. F3 sind über Steckverbindungen S2 bzw. S3 mit dem Systembus BUS verbunden und die Widerstände R21 bzw. R31 über Steckverbindungen S27 und S28 bzw. S37 und S38 parallel zu dem Vorwiderstand R der Stromversorgungseinrichtung geschaltet. Der Einschub E2 enthält eine Leuchtdiode LED21, und der Einschub E3 weist zwei Leuchtdioden LED31 und LED32 auf, die mit Hilfe der Steckvorrichtungen S20 und S21 bzw. S30, S31 und S32 parallel zu den Kollektor-Emitter-Strecken von hier nicht dargestellten Optokopplern des Teils 1 des elektrischen Gerätes geschaltet sind. Sämtliche Leuchtdioden sind über die Steckverbindungen S16, S26 und S36 in Reihe geschaltet und mit Hilfe der Steckverbindungen S10 und S40 an die Stromversorgungseinrichtung mit der Betriebsspannung $U_{B1}$ und dem Vorwiderstand R angeschlossen.

Die Informationen über die Betriebszustände der Funtionseinheiten F1, F2 und F3 gelangen über den Systembus BUS in einen nicht dargestellten Digitalspeicher, der in dem Teil 1 des elektrischen Gerätes enthalten ist. Der Digitalspeicher steuert gemäss dem anzuzeigenden Betriebszustand über die Optokoppler die Helligkeit der Leuchtdioden.

Zur Steuerung des Digitalspeichers IC und der Funktionseinheiten F1 bis F3 kann an den Systembus BUS ein in den Figuren 1 und 2 nicht dargestellter Mikroprozessor angeschlossen sein.

**Patentansprüche**

1. Elektrisches Gerät mit einer Schaltungsanordnung zur Anzeige mehrerer Betriebszustände durch Leuchtdioden (LED1 ... LEDn), die in Reihe geschaltet und an eine Stromversorgungseinrichtung ($U_{B1}$) angeschlossen sind, wobei jeder Leuchtdiode eine steuerbare Schalteinrichtung zugeordnet ist, deren Schaltstrecke (T1 ... Tn) parallel zur Leuchtdiode und deren Steuereingang an jeweils einen Ausgang des elektrischen Gerätes (IC) angeschlossen ist, dadurch gekennzeichnet, dass die Schalteinrichtung eine Schalteinrichtung mit galvanischer Trennung von Schaltstrecke und Steuereingang ist und dass parallel zu jeder Leuchtdiode eine Vorrichtung zur Spannungsbegrenzung (D1 ... Dn) geschaltet ist.

2. Elektrisches Gerät nach Anspruch 1, dadurch gekennzeichnet, dass jede Schalteinrichtung ein Optokoppler ist.

3. Elektrisches Gerät nach Anspruch 1 oder 2, dadurch gekennzeichnet, dass jede Vorrichtung zur Spannungsbegrenzung aus einer Zenerdiode besteht.

4. Elektrisches Gerät nach einem der vorangehenden Ansprüche, dadurch gekennzeichnet, dass das elektrische Gerät eine Speichervorrichtung enthält, in der die anzuzeigenden Betriebszustände gespeichert sind und an deren Ausgänge die Steuereingänge der Schalteinrichtungen angeschlossen sind.

5. Elektrisches Gerät nach einem der vorangehenden Ansprüche in Einschubtechnik, dadurch gekennzeichnet, dass die Einschübe eine oder mehrere der Leuchtdioden und jeweils einen Widerstand (R11, R21, R31) in einer derartigen elektrischen Verbindung mit der Steckeinrichtung des jeweiligen Einschubs aufweisen, dass im gesteckten Zustand der Einschübe die Leuchtdioden aller Einschübe in Reihe geschaltet und die Widerstände parallel zu einem Vorwiderstand (R) geschaltet sind, der zusammen mit einer Spannungsquelle (U$_{B1}$) die Stromversorgungseinrichtung bildet.

## Claims

1. An electrical device with a circuit arrangement for displaying a plurality of operating states by luminescence diodes (LED1 . . . LEDn) connected in series to a current supply device (U$_{B1}$), where each luminescence diode is assigned a controllable switching device whose switching path (T1 . . . Tn) is connected in parallel to the luminescence diode, and whose control input is connected to a respective output of the electric device (IC), characterised in that the switching path and control input of the switching device are mutually isolated electrically, and that a repsective voltage limiter (D1 . . . Dn) is connected in parallel with each luminescence diode.

2. An electrical device as claimed in claim 1, characterised in that each switching device is an opto-coupler.

3. An electrical device as claimed in claim 1 or 2, characterised in that each voltage limiting device is a Zener diode.

4. An electrical device as claimed in one of the preceding claims, characterised in that a storage device stores the operating states to be displayed, with outputs connected to the control inputs of the switching devices.

5. An electrical device as claimed in one of the preceding claims, in plug-in module technology, characterised in that the plug-in modules each contain one or more of the luminescence diodes and a resistor (R11, R21, R31) electrically connected to the plug-in device of the respective plug-in module such that when the plug-in modules are plugged in, the luminescence diodes of all the plug-in modules are connected in series and the resistors are connected in parallel to form a series resistor (R) which forms a current supply device together with a voltage source (U$_{B1}$).

## Revendications

1. Appareil électrique comportant un montage permettant d'afficher plusieurs états de fonctionnement à l'aide de diodes à luminescence (LED1 . . . LEDn), qui sont branchées en séries et sont raccordées à un dispositif (U$_{B1}$) d'alimentation en courant, et dans lequel à chaque diode à luminescence est associé un dispositif de commutation pouvant être commandé et dont la voie de commutation (T1 . . . Tn) est branchée en parallèle avec la diode à luminescence et dont l'entrée de commande est raccordée à une sortie respective de l'appareil électrique (IC), caractérisé par le fait que le dispositif de commutation est un dispositif de commutation, dans lequel il existe une séparation galvanique entre la voie de commutation et l'entrée de commande, et qu'un dispositif (D1 . . . Dn) servant à limiter la tension est branché en parallèle avec chaque diode à luminescence.

2. Appareil électrique suivant la revendication 1, caractérisé par le fait que chaque dispositif de commutation est un optocoupleur.

3. Appareil électrique suivant la revendication 1 ou 2, caractérisé par le fait que chaque dispositif servant à limiter la tension est contribué par une diode Zener.

4. Appareil électrique suivant l'une des revendications précédentes, caractérisé par le fait qu'il contient un dispositif de mémoire, dans lequel les états de fonctionnement devant être affichés sont mémorisés et aux sorties duquel se trouvent raccordées les entrées de commande des dispositifs de commutation.

5. Appareil électrique suivant l'une des revendications précédentes, réalisé selon la technique modulaire à tiroirs, caractérisé par le fait que les tiroirs comportent une ou plusieurs des diodes à luminescence et respectivement une résistance (R11, R21, R31), qui sont reliées au dispositif d'enfichage du tiroir respectif selon une liaison électrique telle que, lorsque les tiroirs sont à l'état enfiché, les diodes à luminescence de tous les tiroirs sont branchées en séries et les résistances sont branchées en parallèle avec une résistance additionnelle (R) qui forme, avec une source de tension (U$_{B1}$), le dispositif d'alimentation en courant.

FIG 1

FIG 2